# EUROPÄISCHE PATENTANMELDUNG

(11) **EP 0 981 159 A1**
(43) Veröffentlichungstag der Anmeldung: **23.02.2000**
(21) Anmeldenummer: 98115476.8
(22) Anmeldetag: 18.08.1998
(51) Int. Cl.: H01L 23/10, H01L 21/50, B23K 35/30, B23K 35/26, B23K 35/02

(54) **Verfahren zur Herstellung einer Mikroverbindung, mikroelektronisches System sowie nach dem Verfahren hergestellter Infrarotdetektor und dessen Verwendung**

(71) Anmelder: Siemens Building Technologies AG, 8708 Männedorf (CH)
(72) Erfinder: Wälti, Marc, 8604 Kindhausen-Volketswil (CH)
(74) Vertreter: Dittrich, Horst, Dr.

(57) **Zusammenfassung**

Eine Mikroverbindung zwischen zwei Fügeteilen (1, 8) wird durch kontrolliertes Diffusionsschweissen mit Phasenbildung hergestellt. Dabei wird auf die Fügeteile (1, 8) eine niedrig- und eine hochschmelzende Komponente aufgebracht und die Fügeteile werden in Kontakt gebracht. Anschliessend wird die Temperatur auf einen Wert zwischen den Schmelzpunkten der beiden Komponenten erhöht, wobei eine fest-flüssig Interdiffusion stattfindet. Die Mikroverbindung wird durch isotherme Erstarrung hergestellt, wobei eine neue Komponente gebildet wird, deren Schmelzpunkt über der Prozesstemperatur, aber unter dem Schmelzpunkt der hochschmelzenden Komponente liegt. Als hochschmelzende Komponente wird Gold und als niedrigschmelzende Komponente Indium oder Zinn verwendet.

Ein nach dem Verfahren hergestellter Infrarotdetektor besteht aus einem Substrat (1) mit einem Infrarotsensor (3) und aus einem vor diesem angeordneten, mit dem Substrat (1) verbundenen, infrarotdurchlässigen Fenster (8), wobei zwischen dem Infrarotsensor (3) und dem Fenster (8) ein Hohlraum mit einem Vakuum gebildet ist. Die Verbindung zwischen dem Substrat (1) und dem Fenster (8) ist eine durch isotherme Erstarrung hergestellte Mikroverbindung, und die hochschmelzende Komponente dieser Mikroverbindung dient als Abstandhalter (7) zwischen dem Substrat (1) und dem Fenster (8).

## Beschreibung

Die vorliegende Erfindung betrifft ein Verfahren zur Herstellung einer Mikroverbindung zwischen zwei Fügeteilen durch kontrolliertes Diffusionsschweissen mit Phasenbildung, bei welchem aufdie Fügeteile eine niedrig- und eine hochschmelzende Komponente aufgebracht wird, die Fügeteile in Kontakt gebracht werden und anschliessend die Temperatur auf einen Wert zwischen den Schmelzpunkten der beiden Komponenten erhöht wird, wobei eine fest-flüssig Interdiffusion stattfindet.

Das Diffusionsschweissen, das sich hervorragend zur weiteren Miniaturisierung elektronischer Baugruppen eignet, erhöht gegenüber dem Löten die Herstellungsqualität und die physikalische Zuverlässigkeit und stellt eine hochwertige Simultankontaktierungstechnik zur Verfügung. Das Fügeverfahren des Diffüsionsschweissens mit Phasenbildung basiert auf der vollständigen Umsetzung einer aufgebrachten Dünnschicht mit der Anschlussmetallisierung zu intermetallischer Phase durch Festkörperdiffusion.

Die hohe Schmelztemperatur intermetallischer Phasen führt zu einer niedrigen homologen Betriebstemperatur und daraus resultiert ein hoher Widerstand gegen irreversiblen chemischen Transport. Zu einer ausführlichen Beschreibung des Diffusionsschweissens wird aufden Artikel 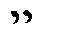 Mikroverbindungen erhöhter Leistungsdichte - Kontrolliertes Diffusionsschweissen mit Phasenbildung" von T. Harder und H. Hieber in DVS 148, 207-208 und auf die in diesem Artikel zitierten Literaturstellen verwiesen.

Trotz seiner unbestreitbaren Vorteile hat das Diffusionsschweissen aber auch gewisse Nachteile, zu denen insbesondere die langen Prozesszeiten und die zur Anwendung kommenden hohen Drücke und Temperaturen zählen.

Durch die Erfindung soll nun ein Verfahren zur Herstellung einer Mikroverbindung angegeben werden, welches sich durch kürzere Prozesszeiten und niedrigere Temperaturen und Drücke auszeichnet.

Diese Aufgabe wird erfindungsgemäss dadurch gelöst, dass die Mikroverbindung durch isotherme Erstarrung hergestellt wird, wobei eine neue Komponente gebildet wird, deren Schmelzpunkt über der Prozesstemperatur, aber unter dem Schmelzpunkt der hochschmelzenden Komponente liegt, und dass als hochschmelzende Komponente Gold und als niedrigschmelzende Komponente Indium oder Zinn verwendet wird.

Das erfindungsgemässe Verfahren, bei dem die Mikroverbindung durch isotherme Erstarrung hergestellt wird, hat neben kurzen Prozesszeiten und niedrigen Temperaturen und Drücken noch den ganz wesentlichen Vorteil, dass die auf diese Weise hergestellten Verbindungen deutlich höhere Temperaturen als die für ihre Herstellung angewendeten ertragen. Mit isothermer Erstarrung lassen sich Verbindungen fertigen, die danach weitere Aufbauschritte, sogenannte Step-Prozesse, durchlaufen müssen. Solche Mehrschrittaufbauten werden zur Zeit durch Löten realisiert, wobei jedoch jede nachfolgende Stufe eine deutlich tiefere Löttemperatur aufweisen muss als die bestehende Verbindung, damit diese nicht wieder gelöst wird. Isotherme Erstarrung kann mit einem einzigen System in beliebig vielen Stufen nacheinander ausgeführt und kann auch als Vorstufe zu allen üblichen Loten verwendet werden.

Die Erfindung betrifft weiter ein mikroelektronisches System mit zwei Fügeteilen und einer Mikroverbindung, die unter Verwendung einer niedrig- und einer hochschmelzenden Komponente durch kontrolliertes Diffiisionsschweissen mit Phasenbildung hergestellt ist. Das erfindungsgemässe mikroelektronische System ist dadurch gekennzeichnet, dass die Mikroverbindung durch isotherme Erstarrung hergestellt und die hochschmelzende Komponente durch Gold und die niedrigschmelzende Komponente durch Indium oder Zinn gebildet ist.

Eine erste bevorzugte Ausführungsform des erfindungsgemässen mikroelektronischen Systems ist dadurch gekennzeichnet, dass die Fügeteile durch zwei Substrate gebildet sind und zwischen diesen ein nach aussen luftdicht abgeschlossener Hohlraum zur Aufnahme einer elektronischen und/oder optischen und/oder mechanischen Komponente ausgebildet ist, und dass auf das eine Substrat ein Abstandhalter aus Gold aufgewachsen und auf das andere Substrat ein dünner Film von Indium oder Zinn, gefolgt von einer dünnen Goldschicht, aufgebracht ist.

Dieses mikroelektronische System ist besonders gut als Gehäuse zum Verpacken von Strahlungssensoren, Magnetfeldsensoren, Beschleunigungssensoren, Drucksensoren oder optischen Systemen geeignet, wobei die genannten Sensoren in eine zwischen den beiden Substraten gebildete Kavität hineingepackt werden.

Eine zweite bevorzugte Ausführungsform des erfindungsgemässen mikroelektronischen Systems ist dadurch gekennzeichnet, dass die Fügeteile durch ein Substrat und einen Flip Chip gebildet sind, wobei auf dem Flip Chip Goldanschlüsse aufgewachsen und auf dem Substrat den Goldanschlüssen zugeordnete, mit Indium oder Zinn beschichtete Kontaktpolster vorgesehen sind.

Diese Flip Chips mit isothermer Erstarrung als Verbindungstechnik haben unter anderem den Vorteil, dass die Verbindung bei Temperaturen, wie sie auch beim Löten verwendet werden, hergestellt wird, wobei aber die Temperaturbeständigkeit der isotherm erstarrten Verbindung wesentlich höher ist. Dadurch können nachfolgende Aufbauschritte ohne Sonderlote vorgenommen werden. Ausserdem arbeitet das System flussmittelfrei, so dass auch ohne Waschen keine störenden Rückstände unter dem Chip vorliegen. Über die Höhe der Goldanschlüsse kann der Abstand zwischen Substrat und Chip so eingestellt werden, dass für eine Unterfüllung optimale Voraussetzungen geschaffen werden können.

Eine weitere bevorzugte Ausführungsform des erfindungsgemässen mikroelektronischen Systems ist dadurch gekennzeichnet, dass das eine Fügeteil durch einen Chip und das andere Fügeteil durch einen Flip Chip gebildet ist, wobei auf dem Flip Chip Goldanschlüsse aufgewachsen und auf dem Chip den Goldanschlüssen zugeordnete, mit Indium oder Zinn beschichtete Kontaktstellen vorgesehen sind.

Durch die flussmittelfreie isotherme Erstarrung können nun auch Flip Chip auf Chip (FCOC = Flip Chip on Chip) Verbindungen aufgebaut und beispielsweise in Hörgeräten eingesetzt werden. Bei diesen Verbindungen fällt der Draht Bonding Prozess weg und die Chips brauchen nicht mehr zusammengeklebt zu werden. Da die aktiven Seiten der Chips gegeneinander gerichtet sind, sind diese gegen mechanische Einwirkungen weitgehend geschützt. Ausserdem werden durch die FCOC-Technologie die Signalwege deutlich kürzer, was höhere Signalfrequenzen ermöglicht, und es können durch diesen Aufbau sehr hohe Packungsdichten erreicht werden.

Eine weitere bevorzugte Ausführungsform des erfindungsgemässen mikroelektrischen Systems ist dadurch gekennzeichnet, dass das eine Fügeteil durch einen Chip und das andere durch einen Leadframe gebildet ist, wobei auf dem Chip Goldanschlüsse aufgewachsen und aufdem Leadframe mit Indium oder Zinn beschichtete Kontaktstellen vorgesehen und die elektrischen Anschlüsse direkt auf die Goldanschlüsse gebondet sind.

Die Erfindung betrifft weiter einen nach dem erfindungsgemässen Verfahren hergestellten Infrarotdetektor, welcher aus einem Substrat mit einem Infrarotsensor und aus einem vor diesem angeordneten, mit dem Substrat verbundenen, infrarotdurchlässigen Fenster besteht, wobei zwischen dem Infrarotsensor und dem Fenster ein Hohlraum mit einem Vakuum gebildet ist.

Der erfindungsgemässe Infrarotdetektor ist dadurch gekennzeichnet, dass die Verbindung zwischen dem Substrat und dem Fenster eine durch isotherme Erstarrung hergestellte Mikroverbindung ist, und dass die hochschmelzende Komponente dieser Mikroverbindung als Abstandhalter zwischen dem Substrat und dem Fenster dient.

Eine bevorzugte Ausführungsform des erfindungsgemässen Infrarotdetektors ist dadurch gekennzeichnet, dass der Infrarotsensor durch eine Mehrzahl von Einzelsensoren gebildet ist, von denen jeder eine Thermosäule mit einer Anzahl von in Serie geschalteten Thermoelementen aufweist.

Die Erfindung betrifft weiter eine Verwendung des genannten Infrarotsensors zur Erzeugung von Wärmebildern eines überwachten Raumes zum Zweck der Detektion und/oder Zählung von in diesem Raum anwesenden oder vorhandenen Personen beziehungsweise anderen Wärmequellen.

Der erfindungsgemässe Infrarotdetektor eignet sich somit beispielsweise für das sogenannte Präsenz-Monitoring (Detektion der Anwesenheit und der Anzahl von Personen in einem Raum), für Hot-Spot-Detektion in Frachträumen und Lagerhallen, für die Detektion von Waldbränden, für Bewegungsrichtungsdetektion, und so weiter.

Im folgenden wird die Erfindung anhand eines Ausführungsbeispiels und der Zeichnungen näher erläutert; es zeigt:
- Fig. 1: eine schematische Perspektivdarstellung eines erfindungsgemässen Infrarotdetektors,
- Fig. 2: einen schematischen Querschnitt durch den Infrarotdetektor von Fig. 1; und
- Fig. 3: eine Detailvariante von Fig. 2.

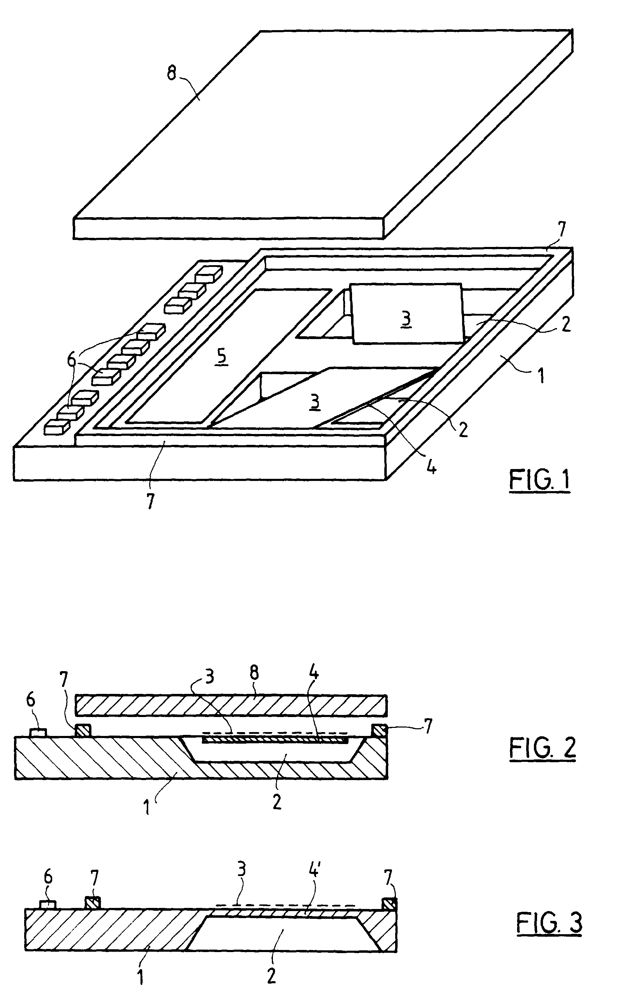

Der in den Figuren 1 und 2 dargestellte Infrarotdetektor besteht aus einem Substrat 1 aus Silizium mit zwei an seiner Vorderseite, das ist in den Figuren oben, herausgeätzten Kavitäten 2, die je von einer mikrobearbeiteten Brücke 4 überspannt sind. Mikrobearbeitet (micromachined) bezeichnet eine Formgebung oder Formveränderung in mikroskopischem Massstab, z.B. eine Ätzung entlang von Gitterebenen. Auf den Brücken 4 ist ein durch ein Array von Einzelsensoren gebildeter Infrarotsensor 3 angeordnet. In Fig. 1 sind zwei Arrays angedeutet, die je durch eine Thermosäule aus in Serie geschalteten Thermoelementen gebildet sind. Die kalten Punkte dieser Thermosäulen liegen aussen am Rand der jeweiligen Kavität 2 auf dem Substrat 1 und die heissen Punkte liegen in der Mitte der Brücken 4.

Bei der in Fig. 3 dargestellten Variante ist eine an der Rückseite des Substrats 1 herausgeätzte Kavität 2 vorgesehen, die nach oben von einer als Träger des Infrarotsensors 3 dienenden Membran 4' abgeschlossen ist.

Seitlich neben den Kavitäten 2 ist auf dem Substrat die elektronische Schaltung 5 des Infrarotdetektors schematisch dargestellt, von der nicht eingezeichnete Verbindungen zu seitlich auf das Substrat aufgewachsenen Goldanschlüssen 6 (bumps) geführt sind. Die Kavitäten 2 mit dem Infrarotsensor 3 und die Schaltung 5 sind von einem Abstandhalter 7 aus Gold umgeben, wobei das Gold als hochschmelzende Komponente einer durch isotherme Erstarrung herzustellenden Mikroverbindung zwischen dem Substrat 1 und einem den Infrarotsensor 3 und die Schaltung 5 abdeckenden Infrarotfenster oder Infrarotfilter 8 vorgesehen ist. Die niedrigschmelzende Komponente dieser Mikroverbindung ist durch Indium oder Zinn gebildet.

Bei der isothermen Erstarrung werden eine niedrig- und eine hochschmelzende Komponente auf die Fügepartner aufgebracht, dann werden diese in Kontakt gebracht und die Temperatur wird auf einen Wert oberhalb des Schmelzpunkts der niedrigschmelzenden Komponente erhöht. Darauf findet ein fest-flüssig Interduffüsion statt (SLID - solid liquid interdiffüsion), in deren Folge sich hochschmelzende Komponenten (intermetallische Phasen) bilden. Die Verbindung erstarrt isotherm.

Zwischen dem Infrarotfenster 8 und dem Infrarotsensor 3 ist ein Hohlraum mit einem Vakuum gebildet. Der goldene Abstandshalter 7 ist aufdas Silizium-Substrat 1 aufgewachsen und das Indium oder Zinn ist aufentsprechende Stellen des Infrarotfensters 8 als dünner Film aufgebracht, der von einer dünnen Goldschicht gefolgt ist. Die Höhe des Hohlraums ist über die Höhe des Abstandshalters 7 einstellbar. Unterhalb des Goldes des Abstandshalters 7 ist eine als Diffusionsbarriere dienende Schicht aus Titanwolfram angeordnet. Unter dem Indium oder Zinn sind zwei Schichten, eine Adhäsionsschicht und eine Benetzungsschicht, vorgesehen. Die Adhäsionsschicht besteht aus Chrom, Titan oder Chromnickel und die Benetzungsschicht besteht aus Kupfer oder Nickel.

Für andere Anwendungen kann die Versiegelung des Hohlraums lokal unterbrochen sein, oder es können mehrere, hermetisch getrennte Hohlräume vorliegen. Mit derselben Technik können auch Leitungen und Kanäle implementiert werden, so dass zum Beispiel ein Messmedium selektiv zu einer Sensoreinheit geführt werden kann. Die Auswerteschaltung ist in diesem Fall monolithisch integriert und von der Sensoreinheit hermetisch getrennt. In den Kanälen können sich mikromechanische Ventile befinden, und die Abstandshalter können als passive Ausrichthilfen für eingelegte optische Komponenten verwendet werden. Mit dieser Verpackungsmethode können Strömungssensoren, optische Systeme, chemische oder biologische Sensoren verarbeitet werden.

Der Infrarotsensor 3 ist eine Thermosäule aus 20 bis 200 in Serie geschalteten Thermoelementen aus Poly-Silizium und Aluminium. Die Thermosäule ist auf der wenige Mikrometer dicken, thermisch isolierenden Membran 4' (Fig. 3) aufgebaut, die aus Siliziumoxid und Silizium-Oxynitrid besteht, welche aufeinem gewöhnlichen Siliziumchip abgeschieden werden. Anschliessend wird das Silizium von der Rückseite her mit Kalilauge weggeätzt, bis nur die Oxid- und die Oxynitridschicht übrig bleiben, wobei die letztere sehr robust ist und eine sehr geringe Wärmeleitfähigkeit aufweist. Bei vorderseitiger Ätzung (Fig. 1, 2) wird ein anderes Ätzmittel verwendet. Die Abmessungen eines einzelnen Thermosäulen-Sensors betragen beispielsweise 0.25 mal 0.25 mm.

Zur Erzeugung eines Wärmebildes benötigt man ein sequentiell angesteuertes, zweidimensionales Array solcher Thermosäulen-Sensoren, von denen jeder ein Bildelement (Pixel) darstellt. Zur Trennung der einzelnen Pixel voneinander ist die die Thermosäule tragende Membran mit einem Gitter von senkrecht zueinander stehenden Goldlinien von etwa 25 Mikrometer Höhe überzogen. Die Goldlinien, die durch Elektroformieren abgeschieden sind, führen die Wärme von der Membran zum Siliziumsubstrat 1, wodurch eine mechanische Versteifung der Membran bewirkt wird.

Die elektronische Schaltung 5 enthält unter anderem eine Verstärkungsstufe zur Verstärkung der an den Anschlüssen der Thermosäule entstehenden sehr geringen Spannung in der Grössenordnung von etwa 0.1 Mikrovolt. Um ein Wärmebild zu gewinnen und dieses auf einem Bildschirm darzustellen, muss der Verstärker das Array von Sensoren sequentiell ansteuern, was mit einer sogenannten Time-Domain Multiplexschaltung erfolgt. Die Signale werden schliesslich auf dem Bildschirm zu einem farbigen Wärmebild zusammengesetzt. Ab einer gewissen Mindestanzahl von etwa 28 mal 28 Pixeln wird es möglich, Objekte wie Tiere und Menschen voneinander zu unterscheiden und auch die Bewegungsrichtung der Objekte zu ermitteln.

Neben dieser Anwendung als Einbruchmelder bestehen noch zahlreiche weitere Anwendungsmöglichkeiten für einen Sensor der beschriebenen Art. So beispielsweise als Flammen- und Waldflammensensor, als Detekor für Hot-spots in Lagerhallen oder in Frachträumen von Schiffen oder Flugzeugen, zur Bewegungsrichtungsdetektion (Tracking) und damit verbunden zur Steuerung von Barrieren oder Türen, so dass diese nur aufgehen, wenn sich eine Person aufsie zu bewegt, zum Präsenz-Monitoring, zur Personenzählung, und so weiter.

Präsenz-Monitoring und Personenzählung können wiederum zur Steuerung verschiedenster Prozesse eingesetzt werden. So kann beispielsweise Präsenz-Monitoring dazu verwendet werden, automatisch zu prüfen, ob der Beifahrersitz eines Autos besetzt ist und ob durch einen Erwachsenen oder ein Kind, so dass bei einer Kollision eine unerwünschte Auslösung des Airbags verhindert werden kann. Eine weitere Anwendungsmöglichkeit ist das Ein- und Ausschalten der Beleuchtung in Abhängigkeit von der Anwesenheit einer Person in einem Raum. Personenzählung kann beispielsweise zur Steuerung der Belüftung und/oder Klimatisierung von Räumen verwendet werden.

Die in Zusammenhang mit einem Infrarotdetektor beschriebene, durch isotherme Erstarrung hergestellte Mikroverbindung eignet sich aber nicht nur für das beschriebene sogenannte housing sondern noch für andere Verpackungsarten, von denen insbesondere die folgenden zu nennen sind:
■ Waferbonding mit dünnen Filmen: Mit diesem Verfahren können Sandwiches aus zwei oder mehr Wafern realisiert werden. Bei einem Aufbau aus beispielsweise drei Wafern ist der mittlere Wafer prozessiert und hat aufeiner Seite ein Goldstruktur. Auf der anderen Seite ist eine dünne Goldschicht aufgebracht, die gleichzeitig auch als Maske für micromachining gebraucht werden kann. Dann werden aufbeiden Seiten durch isotherme Erstarrung Wafer fixiert. Der strukturierte Wafer hat dadurch auf beiden Seiten Kavitäten, die aufder einen Seite durch die Goldstruktur und auf der anderen Seite durch micromaching gebildet sind.
■ Flip Chip: Ein konventioneller Flip Chip bildet das eine Fügeteil, welches mit dem durch ein Substrat gebildeten anderen Fügeteil durch isotherme Erstarrung verbunden wird. Zu diesem Zweck werden auf dem Flip Chip Goldanschlüsse aufgewachsen, die mit Indium-beschichteten Kontaktpolstern auf dem Substrat verbunden werden. Die weichen Goldanschlüsse dienen als Puffer für thermomechanische Spannungen, wie sie bei unterschiedlichen thermischen Ausdehnungskoeffizienten von Chip und Substrat auftreten. Über die Höhe der Goldanschlüsse wird der Abstand zwischen Substrat und Chip eingestellt. Da das System ohne Flussmittel arbeitet, liegen auch ohne Waschen keine störenden Rückstände unter dem Chip vor.

Die Verbindung wird bei Temperaturen hergestellt, wie sie auch beim Löten verwendet werden. Im Unterschied zum Löten ist aber die Temperaturbeständigkeit der isotherm erstarrten Verbindung deutlich höher, so dass nachfolgende Aufbauschritte ohne Sonderlote vorgenommen werden können.
■ Flip Chip on Chip (FCOC): Chip on Chip (COC) wird heute bereits bei Hörgeräten verwendet. Durch die flussmittelfreie isotherme Erstarrung Gold/Indium oder Zinn können nun auch Flip Chip auf Chip aufgebaut werden, wodurch der Draht Bonding Prozess wegfällt und die Chips nicht zusammengeklebt werden müssen. Die aktiven Seiten der Chips werden gegeneinander gerichtet, so dass sie gegen mechanische Einwirkungen geschützt sind. Durch die FCOC-Technologie werden die Signalwege deutlich kürzer, was höhere Signalfrequenzen ermöglicht. Ausserdem können durch diesen Aufbau sehr hohe Packungsdichten erreicht werden.
■ Lead on Chip (LOC) und Tape Automated Bonding (TAB): Lead on Chip ist eine Verpackungsmethode, bei welcher der Leadframe, das ist ein plattenartiger Träger mit Anschlussdrähten, direkt auf den Chip geklebt und dann mit Draht Bonding verdrahtet wird, wobei Standard-Leadframes von normaler Dicke verwendet werden. Beim TAB werden wesentlich dünnere Leadframes verwendet, die über Thermokompressions-Bonding elektrisch kontaktiert werden. Diese Leadframes sind aber zu dünn, um sie mit einer üblichen SMD (Surface Mounted Device) Einrichtung verarbeiten zu können.

Mit Hilfe der isothermen Erstarrung ist es möglich, Leadframes von normaler Dicke in einer TAB-ähnlichen Weise zu verarbeiten. Dabei werden die elektrischen Anschlüsse direkt aufdie Goldanschlüsse gebondet. Für den in den Figuren dargestellten Infrarotdetektor mit der Thermosäule wird zusätzlich der Leadframe aufdem Goldabstandshalter 7 fixiert und das Infrarotfenster 8 wird mit isothermer Erstarrung auf den Leadframe gebondet. Dadurch entsteht zwischen Chip (Substrat 1 plus Infrarotsensor 3) und Infrarotfenster 8 ein grösserer Abstand, was die Empfindlichkeit des Sensors deutlich erhöht. Das System wird anschliessend mit Epoxy vergossen und kann dann in normaler SMD-Technologie verarbeitet werden.

## Patentansprüche

1. Verfahren zur Herstellung einer Mikroverbindung zwischen zwei Fügeteilen (1, 8) durch kontrolliertes Diffusionsschweissen mit Phasenbildung, bei welchem auf die Fügeteile (1, 8) eine niedrig- und eine hochschmelzende Komponente aufgebracht wird, die Fügeteile in Kontakt gebracht werden und anschliessend die Temperatur auf einen Wert zwischen den Schmelzpunkten der beiden Komponenten erhöht wird, wobei eine fest-flüssig Interdiffüsion stattfindet, dadurch gekennzeichnet, dass die Mikroverbindung durch isotherme Erstarrung hergestellt wird, wobei eine neue Komponente gebildet wird, deren Schmelzpunkt über der Prozesstemperatur, aber unter dem Schmelzpunkt der hochschmelzenden Komponente liegt, und dass als hochschmelzende Komponente Gold und als niedrigschmelzende Komponente Indium oder Zinn verwendet wird.

2. Mikroelektronisches System mit zwei Fügeteilen (1, 8) und einer Mikroverbindung die unter Verwendung einer niedrig- und einer hochschmelzenden Komponente durch kontrolliertes Diffusionsschweissen mit Phasenbildung hergestellt ist, dadurch gekennzeichnet, dass die Mikroverbindung durch isotherme Erstarrung hergestellt und die hochschmelzende Komponente durch Gold und die niedrigschmelzende Komponente durch Indium oder Zinn gebildet ist.

3. Mikroelektronisches System nach Anspruch 2, dadurch gekennzeichnet, dass die Fügeteile (1, 8) durch zwei Substrate gebildet sind und zwischen diesen ein nach aussen luftdicht abgeschlossener Hohlraum (2) zur Aufnahme einer elektronischen und/oder optischen und/oder mechanischen Komponente (3) ausgebildet ist, und dass auf das eine Substrat (1) ein Abstandhalter (7) aus Gold aufgewachsen und auf das andere Substrat (8) ein dünner Film von Indium oder Zinn, gefolgt von einer dünnen Goldschicht, aufgebracht ist.

4. Mikroelektronisches System nach Anspruch 2, dadurch gekennzeichnet, dass die Fügeteile durch ein Substrat und einen Flip Chip gebildet sind, wobei auf dem Flip Chip Goldanschlüsse aufgewachsen und auf Substrat den Goldanschlüssen zugeordnete, mit Indium oder Zinn beschichtete Kontaktpolster vorgesehen sind.

5. Mikroelektronisches System nach Anspruch 2, dadurch gekennzeichnet, dass das eine Fügeteil durch einen Chip und das andere Fügeteil durch einen Flip Chip gebildet ist, wobei aufdem Flip Chip Goldanschlüsse aufgewachsen und auf dem Chip den Goldanschlüssen zugeordnete, mit Indium oder Zinn beschichtete Kontaktstellen vorgesehen sind.

6. Mikroelektronisches System nach Anspruch 2, dadurch gekennzeichnet, dass das eine Fügeteil durch einen Chip und das andere durch einen Leadframe gebildet ist, wobei auf dem Chip Goldanschlüsse aufgewachsen und auf dem Leadframe mit Indium oder Zinn beschichtete Kontaktstellen vorgesehen und die elektrischen Anschlüsse direkt auf die Goldanschlüsse gebondet sind.

7. Nach dem Verfahren gemäss Anspruch 1 hergestellter Infrarotdetektor, welcher aus einem Substrat (1) mit einem Infrarotsensor (3) und aus einem vor diesem angeordneten, mit dem Substrat (1) verbundenen, infrarotdurchlässigen Fenster (8) besteht, wobei zwischen dem Infrarotsensor (3) und dem Fenster (8) ein Hohlraum mit einem Vakuum gebildet ist, dadurch gekennzeichnet, dass die Verbindung zwischen dem Substrat (1) und dem Fenster (8) eine durch isotherme Erstarrung hergestellte Mikroverbindung ist, und dass die hochschmelzende Komponente dieser Mikroverbindung als Abstandhalter (7) zwischen dem Substrat (1) und dem Fenster (8) dient.

8. Infrarotdetektor nach Anspruch 8, dadurch gekennzeichnet, dass der Infrarotsensor (3) durch eine Mehrzahl von Einzelsensoren gebildet ist, von denen jeder eine Thermosäule mit einer Anzahl von in Serie geschalteten Thermoelementen aufweist.

9. Infrarotdetektor nach Anspruch 8, dadurch gekennzeichnet, dass die Thermosäulen je auf einer isolierenden und über eine im Substrat (1) vorgesehene Kavität (2) gespannten Membran (4, 4') aufgebaut sind, und dass die kalten Punkte der Thermosäulen an den Rand der Kavität (2) und die heissen Punkte auf die Mitte der Membran (4, 4') geführt sind.

10. Infrarotdetektor nach Anspruch 9, dadurch gekennzeichnet, dass jede Thermosäule aus 20 bis 200 Themoelementen besteht, deren einer Draht aus Poly-Silizium und deren anderer Draht aus Aluminium besteht.

11. Verwendung des Infrarotdetektors gemäss einem der Ansprüche 8 bis 10 zur Erzeugung von Wärmebildem eines zu überwachenden Raumes zum Zweck der Detektion und/oder Zählung von in diesem Raum anwesenden oder vorhandenen Personen beziehungsweise anderen Wärmequellen.
